# FASCICULE DE BREVET EUROPEEN

(11) **EP 3 757 756 B1**
(45) Date de publication et mention de la délivrance du brevet: **11.11.2026**
(21) Numéro de dépôt: 20178996.3
(22) Date de dépôt: 09.06.2020
(51) Int. Cl.: G06F 7/544, G06F 7/483

(54) **OPÉRATEUR DE PRODUIT SCALAIRE DE NOMBRES À VIRGULE FLOTTANTE RÉALISANT UN ARRONDI CORRECT**
OPERATIONSEINHEIT EINES SKALARPRODUKTS VON GLEITKOMMAZAHLEN, DIE EINE KORREKTE RUNDUNG ERZIELT
OPERATOR FOR SCALAR PRODUCT OF NUMBERS WITH FLOATING COMMA FOR PERFORMING CORRECT ROUNDING OFF

(30) Priorité: 25.06.2019 FR 1906887
(43) Date de publication de la demande: 30.12.2020
(73) Titulaire: Kalray, 38330 Montbonnot Saint Martin (FR)
(72) Inventeur: BRUNIE, Nicolas, 38000 GRENOBLE (FR)
(74) Mandataire: de Jong, Jean Jacques

(56) Documents cités:
- US-A1- 2005 177 610
- US-A1- 2018 315 399
- US-A1- 2018 322 607
- DIPANKAR DAS ET AL: "Mixed Precision Training of Convolutional Neural Networks using Integer Operations", ARXIV.ORG, CORNELL UNIVERSITY LIBRARY, 201 OLIN LIBRARY CORNELL UNIVERSITY ITHACA, NY 14853, 3 February 2018 (2018-02-03), XP081214609
- MATTHIEU COURBARIAUX ET AL: "Training deep neural networks with low precision multiplications", CORR (ARXIV), vol. 1412.7024, no. v5, 23 September 2015 (2015-09-23), pages 1 - 10, XP055566721

## Description

### Domaine

L'invention est relative à des opérateurs matériels de traitement de nombres à virgule flottante d'un cœur de processeur, et plus particulièrement à un opérateur de calcul d'un produit scalaire sur la base d'un opérateur de multiplication et addition fusionnées, plus couramment désigné par FMA (du terme anglais « Fused Multiply-Add »).

### Arrière-plan

Les technologies d'intelligence artificielle, notamment l'apprentissage profond, sont particulièrement consommatrices de multiplications de grandes matrices, pouvant avoir plusieurs centaines de lignes et de colonnes. On assiste ainsi à l'émergence d'accélérateurs matériels spécialisés dans les multiplications de matrices en précision mixte.

La multiplication de grandes matrices est généralement effectuée par blocs, c'est-à-dire en passant par une décomposition des matrices en sous-matrices de taille adaptée aux ressources de calcul. Les accélérateurs sont ainsi conçus pour calculer efficacement les produits de ces sous-matrices. De tels accélérateurs comportent notamment un opérateur capable, en un cycle d'instruction, de calculer le produit scalaire des vecteurs représentant une rangée et une colonne de sous-matrice et d'ajouter le résultat partiel correspondant à des résultats partiels accumulés lors de cycles précédents. Au bout d'un certain nombre de cycles, l'accumulation des résultats partiels constitue le produit scalaire des vecteurs représentant une rangée et une colonne d'une matrice complète.

De tels opérateurs font usage des techniques de multiplication et addition fusionnées ou FMA.

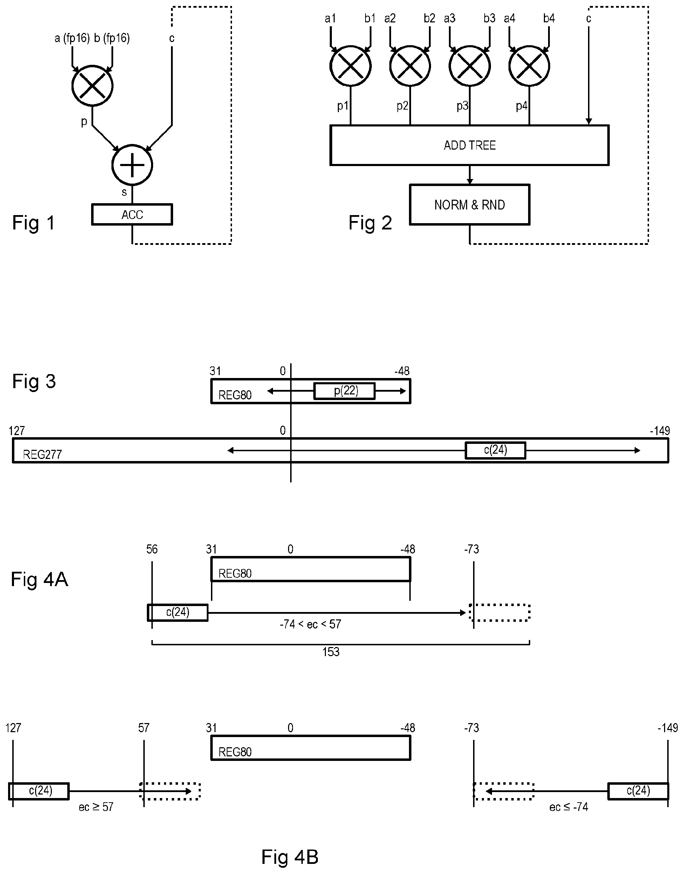

La figure 1 illustre schématiquement un opérateur FMA classique. L'opérateur prend généralement trois opérandes binaires à virgule flottante, à savoir deux opérandes de multiplication, ou multiplicandes *a* et *b,* et un opérande d'addition *c*. Il calcule le terme ab+c pour produire un résultat *s* dans un registre désigné par ACC. Le registre est ainsi désigné, car il est généralement utilisé pour accumuler plusieurs produits en plusieurs cycles, en réutilisant, comme cela est illustré par une ligne en pointillés, la sortie du registre comme opérande d'addition *c* au cycle suivant.

Dans l'article ["Modified Fused Multiply and Add for Exact Low Precision Product Accumulation", Nicolas Brunie, IEEE 24th Symposium on Computer Arithmetic (ARITH), July 2017], les multiplicandes a et b sont dans un format à virgule flottante de demi-précision, aussi appelé « binary16 » ou « fp16 », selon la norme IEEE-754. Un nombre dans le format « fp16 » possède un bit de signe, un exposant de 5 bits, et une mantisse de 10+1 bits (dont un bit implicite codé dans l'exposant).

Le registre ACC est conçu pour contenir toute la dynamique du produit *ab* dans un format à virgule fixe. Pour des multiplicandes au format « fp16 », il suffit pour cela d'un registre de 80 bits (plus éventuellement quelques bits de débordement), la virgule fixe étant située au rang 49 du registre. L'opérande d'addition *c* est au même format que le contenu du registre ACC.

Cette structure permet d'obtenir un résultat exact pour chaque opération ab+c, et de garder un résultat d'accumulation exact cycle après cycle, tant que le registre ne déborde pas, évitant ainsi les erreurs d'arrondi et la perte de précision liée à l'addition de nombres de signe contraire mais proches en valeur absolue.

L'article susmentionné propose en outre, dans une configuration de FMA à précision mixte, de convertir le contenu du registre en un format de précision supérieure, par exemple « binary32 », à la fin d'une phase d'accumulation. Toutefois, le nombre ainsi converti ne couvre pas toute la dynamique du format « binary32, » puisque l'exposant du produit *ab* n'est défini que sur 6 bits au lieu de 8.

La figure 2 illustre schématiquement une application de la structure FMA à un opérateur de produit scalaire avec accumulation, tel que cela est décrit, par exemple, dans la demande de brevet US 2018/0321938. Quatre paires de multiplicandes (a1, b1), (a2, b2), (a3, b3) et (a4, b4) sont fournies à des multiplieurs respectifs. Les quatre produits résultants p1 à p4, appelés produits partiels, et un opérande d'addition *c* sont additionnés simultanément par un arbre d'addition. Les multiplicandes et l'opérateur d'addition sont tous dans le même format à virgule flottante. Le résultat de l'addition est normalisé et arrondi pour être converti dans le format à virgule flottante de départ, de sorte à être réutilisable comme opérande *c*.

Pour effectuer la somme des produits partiels et de l'opérande d'addition, les exposants de ces termes sont comparés pour aligner entre elles les mantisses des termes. On ne garde pour l'addition et l'arrondi qu'une fenêtre de bits significatifs correspondant à l'exposant le plus élevé, fenêtre qui correspond à la taille de l'additionneur. En conséquence, les mantisses des termes d'exposants inférieurs sont tronquées, ou totalement éliminées, ce qui produit des erreurs importantes lorsque deux produits partiels d'exposants grands s'annulent mutuellement.

La demande de brevet susmentionnée ne mentionne pas de taille d'additionneur particulière. Dans le même contexte d'addition de produits partiels, la thèse de 2014 de Nicolas Brunie intitulée « Contributions to computer arithmetic and applications to embedded systems », propose une taille d'additionneur égale à deux fois la taille des mantisses des produits partiels plus une marge de dépassement de deux bits, à savoir 98 bits pour des multiplicandes au format binary32. Encore dans le même contexte, le brevet US8615542, pour additionner quatre produits partiels, propose une taille d'additionneur égale seulement à la taille des mantisses des multiplicandes, à savoir 24 bits pour des multiplicandes au format binary32.

Les demandes de brevet US 2018/322607 A1 et US 2005/177610 A1 divulguent également des solutions pour le calcul d'une opération de multiplication et addition fusionnées.

### Résumé

On prévoit de façon générale un opérateur matériel de multiplication et addition fusionnées, comprenant un multiplieur recevant deux multiplicandes sous forme de nombres à virgule flottante codés dans un premier format de précision ; un circuit d'alignement associé au multiplieur, configuré pour, sur la base des exposants des multiplicandes, convertir le résultat de la multiplication en un premier nombre à virgule fixe ayant un nombre de bits suffisant pour couvrir toute la dynamique de la multiplication ; et un additionneur configuré pour additionner le premier nombre à virgule fixe et un opérande d'addition. L'opérande d'addition est un nombre à virgule flottante codé dans un deuxième format de précision ayant une précision supérieure au premier format de précision, et l'opérateur comprend un circuit d'alignement associé à l'opérande d'addition, configuré pour, sur la base de l'exposant de l'opérande d'addition, convertir l'opérande d'addition en un deuxième nombre à virgule fixe de dynamique réduite par rapport à la dynamique de l'opérande d'addition, ayant un nombre de bits égal au nombre de bits du premier nombre à virgule fixe, augmenté de part et d'autre d'au moins la taille de la mantisse de l'opérande d'addition ; et l'additionneur est configuré pour additionner sans perte les premier et deuxième nombres à virgule fixe.

L'opérateur peut comprendre un circuit d'arrondi et de normalisation configuré pour convertir le résultat de l'additionneur en un nombre à virgule flottante dans le deuxième format de précision, en prenant la mantisse sur les bits les plus significatifs du résultat de l'additionneur, calculant l'arrondi à partir des bits restants du résultat de l'additionneur, et déterminant l'exposant à partir de la position du bit le plus significatif dans le résultat de l'additionneur.

Le deuxième nombre à virgule fixe peut être étendu à droite par un nombre de bits au moins égal à la taille de la mantisse de l'opérande d'addition ; et le circuit d'arrondi peut utiliser les bits de l'extension du deuxième nombre à virgule fixe pour calculer l'arrondi.

L'opérateur peut être configuré pour fournir comme résultat l'opérande d'addition lorsque l'exposant de l'opérande d'addition excède la capacité du deuxième nombre à virgule fixe.

Un procédé associé de multiplication et addition fusionnées de nombres binaires comprend des étapes consistant à multiplier les mantisses de deux multiplicandes à virgule flottante codés dans un premier format de précision ; convertir le résultat de la multiplication en un premier nombre à virgule fixe ayant un nombre de bits suffisant pour couvrir toute la dynamique du résultat de la multiplication ; et additionner le premier nombre à virgule fixe et un opérande d'addition. L'opérande d'addition est un nombre à virgule flottante codé dans un deuxième format de précision ayant une précision supérieure au premier format de précision, et le procédé comprend alors des étapes consistant à convertir l'opérande d'addition en un deuxième nombre à virgule fixe de dynamique réduite par rapport à la dynamique de l'opérande d'addition, ayant un nombre de bits égal au nombre de bits du premier nombre à virgule fixe, augmenté de part et d'autre d'au moins la taille de la mantisse de l'opérande d'addition ; et additionner sans perte les premier et deuxième nombres à virgule fixe.

Selon un autre angle, on prévoit de façon générale un opérateur matériel de calcul de produit scalaire, comprenant plusieurs multiplieurs recevant chacun deux multiplicandes sous forme de nombres à virgule flottante codés dans un premier format de précision ; un circuit d'alignement associé à chaque multiplieur, configuré pour, sur la base des exposants des multiplicandes correspondants, convertir le résultat de la multiplication en un nombre à virgule fixe respectif ayant un nombre de bits suffisant pour couvrir toute la dynamique de la multiplication ; et un multi-additionneur configuré pour additionner sans perte les nombres à virgule fixe provenant des multiplieurs, fournissant une somme sous forme de nombre à virgule fixe.

L'opérateur peut comprendre en outre une entrée pour un opérande d'addition à virgule flottante codé dans un deuxième format de précision ayant une précision supérieure au premier format de précision ; un circuit d'alignement associé à l'opérande d'addition, configuré pour, sur la base de l'exposant de l'opérande d'addition, convertir l'opérande d'addition en un nombre à virgule fixe de dynamique réduite par rapport à la dynamique de l'opérande d'addition, ayant un nombre de bits égal au nombre de bits de la somme à virgule fixe, augmenté de part et d'autre d'au moins la taille de la mantisse de l'opérande d'addition ; et un additionneur configuré pour additionner sans perte la somme à virgule fixe et le nombre à virgule fixe de dynamique réduite.

L'opérateur peut comprendre en outre un circuit d'arrondi et de normalisation configuré pour convertir le résultat de l'additionneur en un nombre à virgule flottante codé dans le deuxième format de précision, en prenant la mantisse sur les bits les plus significatifs du résultat de l'additionneur, calculant l'arrondi à partir des bits restants du résultat de l'additionneur, et déterminant l'exposant à partir de la position du bit le plus significatif dans le résultat de l'additionneur.

Le nombre à virgule fixe de dynamique réduite peut être étendu à droite par un nombre de bits au moins égal à la taille de la mantisse de l'opérande d'addition ; et le circuit d'arrondi peut utiliser les bits de l'extension du nombre à virgule fixe de dynamique réduite pour calculer l'arrondi.

L'opérateur peut être configuré pour fournir comme résultat l'opérande d'addition lorsque l'exposant de l'opérande d'addition excède la capacité du nombre à virgule fixe de dynamique réduite.

Un procédé associé de calcul d'un produit scalaire de nombres binaires, comprend des étapes consistant à calculer plusieurs multiplications en parallèle, chacune à partir de deux multiplicandes sous forme de nombres à virgule flottante codés dans un premier format de précision ; sur la base des exposants des multiplicandes de chaque multiplication, convertir le résultat de la multiplication correspondante en un nombre à virgule fixe respectif ayant un nombre de bits suffisant pour couvrir toute la dynamique de la multiplication ; et additionner sans perte les nombres à virgule fixe résultant des multiplications pour produire une somme sous forme de nombre à virgule fixe.

Le procédé peut comprendre en outre des étapes consistant à recevoir un opérande d'addition à virgule flottante codé dans un deuxième format de précision ayant une précision supérieure au premier format de précision ; sur la base de l'exposant de l'opérande d'addition, convertir l'opérande d'addition en un nombre à virgule fixe de dynamique réduite par rapport à la dynamique de l'opérande d'addition, ayant un nombre de bits égal au nombre de bits de la somme à virgule fixe, augmenté de part et d'autre d'au moins la taille de la mantisse de l'opérande d'addition ; et additionner sans perte la somme à virgule fixe et le nombre à virgule fixe de dynamique réduite.

### Description sommaire des dessins

Des modes de réalisation seront exposés dans la description suivante, faite à titre non limitatif en relation avec les figures jointes parmi lesquelles :
[Fig. 1], précédemment décrite, est un schéma de principe d'un opérateur classique d'addition et multiplication fusionnées, dit FMA ;
[Fig. 2], précédemment décrite, est un schéma de principe d'un opérateur classique de produit scalaire avec accumulation ;
[Fig. 3] illustre des nombres dans un format à virgule fixe utilisés dans un opérateur FMA de précision mixte binary16/binary32;
[Fig. 4A] illustre une technique de compression sans perte de la dynamique de la représentation en virgule fixe du format binary32 ;
[Fig. 4B] illustre une technique de compression sans perte de la dynamique de la représentation en virgule fixe du format binary32 ;
[Fig. 5] est un schéma de principe d'un mode de réalisation d'opérateur FMA à précision mixte utilisant la technique des figures 4A et 4B pour réaliser un arrondi correct ; et
[Fig. 6] est un schéma de principe d'un mode de réalisation d'opérateur de produit scalaire et accumulation de précision mixte utilisant la technique des figures 4A et 4B pour réaliser un arrondi correct.

### Description détaillée

Pour améliorer la précision de calcul lors de multiples phases d'accumulation de produits partiels, on souhaite mettre en œuvre un FMA de précision mixte, c'est-à-dire ayant un opérande d'addition de précision supérieure à la précision des multiplicandes. En effet, au cours d'accumulations répétées, l'opérande d'addition a tendance à augmenter sans cesse alors que les produits partiels restent bornés.

L'article IEEE susmentionné de Nicolas Brunie propose une solution offrant des calculs exacts, adaptée à des multiplicandes de format binary16, dont le produit peut être représenté dans un format à virgule fixe à l'aide de 80 bits, format qui reste acceptable pour un traitement matériel au sein des unités de traitement d'un cœur de processeur.

Cependant, le produit de deux nombres binary16 produit un nombre à virgule flottante non standardisé, ayant un bit de signe, 6 bits d'exposant et 21+1 bits de mantisse, codé sur 28 bits. Un tel format ne peut être utilisé que de manière interne. On souhaite alors que l'opérande d'addition soit dans un format standardisé de précision supérieure. Par exemple, l'opérande d'addition peut être de précision immédiatement supérieure, à savoir binary32, ayant un bit de signe, 8 bits d'exposant, et 23+1 bits de mantisse. Le format binary32 nécessiterait ainsi 277 bits pour un codage en virgule fixe, taille trop importante pour un traitement matériel au sein d'un cœur de processeur de complexité réduite que l'on souhaite dupliquer des dizaines de fois dans une puce de circuit intégré.

La figure 3 illustre dans sa partie haute le format à virgule fixe utilisable pour un produit de multiplicandes de format binary16. Le format est matérialisé par un registre de 80 bits REG80 dont les bits sont numérotés par les exposants correspondants du produit. L'exposant 0, correspondant à la virgule fixe, est situé au 49^{e} bit. Le premier bit correspond à l'exposant -48, tandis que le dernier bit correspond à l'exposant 31.

La mantisse p(22) du produit, de 22 bits, est positionnée dans le registre de manière que son bit le plus significatif soit à l'emplacement défini par la somme des exposants des deux multiplicandes, plus 1.

La figure 3 illustre dans sa partie basse le format à virgule fixe utilisable pour un opérande de format binary32. Le format est matérialisé par un registre de 277 bits REG277. La taille requise est donnée par la relation exposant_max - exposant_min + 1 + (taille_mantisse - 1).

L'exposant 0, correspondant à la virgule fixe, est situé au 150^{e} bit. Le premier bit correspond à l'exposant -149, tandis que le dernier bit correspond à l'exposant 127.

La mantisse c(24) de l'opérande, de 24 bits, est positionnée dans le registre de manière que son bit le plus significatif soit à l'emplacement défini par l'exposant de l'opérande.

Pour faire une addition exacte de l'opérande c et du produit p, il faudrait a priori utiliser un additionneur de la taille du plus grand nombre, à savoir 277 bits. Toutefois, comme on souhaite produire un résultat dans un format à virgule flottante standard, ce résultat exact sera forcément arrondi. Dans ce cas, on cherche à assurer que le résultat soit arrondi de manière correcte, c'est-à-dire que le calcul d'arrondi tienne compte de tous les bits du résultat exact.

Pour produire une mantisse correctement arrondie à partir d'un résultat exact ayant plus de bits que la mantisse, on utilise trois bits suivant immédiatement la mantisse dans le résultat exact, appelés bit de garde G, bit d'arrondi R (« round »), et bit collant S (« sticky »). Ces trois bits déterminent s'il faut ou non incrémenter la mantisse selon un mode d'arrondi choisi. Pour assurer la meilleure précision après une séquence de sommes signées, on préfère le mode « au plus proche ».

Il faut cependant noter que la valeur du bit collant S n'est pas strictement la valeur du bit après le bit d'arrondi R - il s'agit d'un bit qui est mis à 1 si l'un quelconque des bits à droite du bit d'arrondi est à 1. Ainsi, pour calculer un arrondi correct en toutes circonstances, on a besoin de tous les bits du résultat exact.

Pour toutefois ramener la taille de l'additionneur à une valeur raisonnable, on utilise la propriété selon laquelle, pour additionner un nombre en virgule fixe de 80 bits et un nombre en virgule fixe de 277 bits, une grande plage du nombre de 277 bits est inutile pour calculer un arrondi correct lors de la conversion du résultat de l'addition en un nombre à virgule flottante. En effet, on peut distinguer deux cas illustrés par les figures 4A et 4B.

La figure 4A illustre un cas nominal où l'opérande c et le produit p peuvent avoir une influence mutuelle qui affecte le résultat de l'addition, soit directement, soit par effet d'arrondi. L'exposant de l'opérande c est compris strictement entre -74 et 57. (Ci-après, le terme « position » est défini par rapport au format à virgule fixe, à savoir qu'une position correspond à un exposant.)

Pour le cas limite de l'exposant 56, la mantisse c(24) est positionnée dans le segment [56:33] du format à virgule fixe et il y a un bit de garde G à la position 32, entre le bit de poids le plus faible de la mantisse c(24) et le bit de poids le plus fort du registre REG80.

Lorsque le registre REG80 contient un nombre positif, le bit de garde G est à 0. L'addition se résume à concaténer le segment [56:32], incluant la mantisse c(24) et le bit de garde, et le registre REG80. Comme on souhaite convertir le résultat de l'addition en un nombre binary32, la mantisse résultante est la mantisse c(24) éventuellement ajustée par arrondi. Pour un arrondi « au plus proche », le bit de garde G à 0 indique qu'il n'y a pas d'ajustement à faire, auquel cas la mantisse c(24) est utilisée directement dans le résultat converti.

Lorsque le contenu du registre REG80 est négatif, le bit de garde G reçoit un bit de signe à 1, auquel cas la mantisse c(24) peut nécessiter un ajustement lors de l'arrondi.

Pour le cas limite de l'exposant -73, la mantisse c(24) est positionnée dans le segment [-73:-96] et il y a 24 bits de garde à 0 [-49:-72] entre le bit de poids le plus faible du registre REG80 et le bit de poids le plus fort de la mantisse c(24).

Dans cette situation, si l'opérande c est positif, l'addition se résume à concaténer le registre REG80 et le segment [-49:-96], incluant les 24 bits de garde à 0 et la mantisse c(24). Comme on souhaite convertir le résultat de l'addition en un nombre binary32, la mantisse résultante est normalement prise dans le registre REG80. Cependant, lorsque le produit est à la plus petite valeur absolue de sa dynamique, à savoir 2⁻⁴⁸, la mantisse du résultat est à prendre sur le dernier bit du registre REG80 et les 23 bits suivants, en fait le segment [-48:-71], laissant encore un bit de garde G à 0 à la position -72, juste devant la mantisse c(24).

Pour un arrondi « au plus proche », le bit de garde G à 0 indique qu'il n'y a pas d'ajustement à faire, auquel cas on utilise directement la mantisse prise dans le registre REG80 étendu par le segment [-49:-71] dans le résultat converti.

Si l'opérande c est négatif, le bit de garde G à la position -72 reçoit un bit de signe à 1, auquel cas, la mantisse prise peut nécessiter un ajustement lors de l'arrondi.

La figure 4B illustre une situation où l'opérande c a un exposant e en dehors du domaine de la figure 4A, à savoir e ≥ 57 ou e ≤ -74. Dans cette situation, le produit p et l'opérande c n'ont pas d'influence mutuelle sur un résultat final à fournir en format binary32. Pour le mode d'arrondi « au plus près », soit l'opérande c est si grand (e ≥ 57) que le produit p n'a pas d'influence et l'opérande c peut être fourni directement comme résultat final, sans effectuer d'addition ; soit l'opérande c est si petit (e ≤ -74) qu'il n'a aucune influence et le contenu du registre REG80 peut être utilisé directement pour le résultat final, sans effectuer d'addition.

Cette situation ne devrait normalement pas arriver, sauf si on fournit une valeur initiale correspondante pour l'opérande c.

Néanmoins, pour garantir que les arrondis sont toujours calculés sur une valeur exacte, et donc garantir qu'ils sont formellement corrects en toutes circonstances et pour tous les modes d'arrondi, tous les bits des mantisses de l'opérande c et du produit p peuvent être pris en compte aussi dans cette situation. En fait, cette situation correspond au cas où les bits de garde G et d'arrondi R sont tous deux à 0, et qu'on s'intéresse seulement à la valeur du bit collant S. Pour le mode d'arrondi « au plus proche » ou « vers 0 », la valeur 0 du seul bit G indique qu'aucun ajustement n'est nécessaire et la valeur du bit S est indifférente. Par contre, pour les modes d'arrondi « vers l'infini », si le signe du résultat correspond à la direction de l'arrondi (par exemple un résultat positif et arrondi « vers plus l'infini »), la valeur 1 du bit S entraîne un incrément de la mantisse, même si les bits G et R sont à 0.

Ainsi, lorsque e ≥ 57, le bit collant S tient compte du contenu du registre REG80.

Lorsque e ≤ -74, le bit collant S tient compte de la mantisse c(24).

Il résulte de ces éléments que, pour calculer le résultat final en format à virgule flottante binary32 correctement arrondi, il suffit de coder l'opérande c en virgule fixe sur le domaine de variation réduit défini à la figure 4A, à savoir sur le segment [56:-96] de 153 bits et de traiter les cas hors-limites de manière spécifique.

La taille de l'additionneur n'est effectivement que de 80 bits étendus de part et d'autre de la taille de la mantisse du résultat, soit 24 + 80 + 24 = 128 bits. Les 25 bits restants à droite sur les 153 bits ne servent qu'au calcul de l'arrondi affectant la mantisse du résultat. Les étages de l'additionneur traitant les 24 bits de poids faible et les 24 bits de poids fort sur les 128 peuvent être simplifiés du fait que ces bits sont tous fixes pour l'entrée recevant le produit p. Le résultat de l'addition peut être exprimé en virgule fixe sur 128+o bits, où o représente quelques bits pour tenir compte d'éventuelles propagations de retenue.

La mantisse du résultat final en format à virgule flottante binary32 est prise sur les 24 bits les plus significatifs du résultat de l'addition, et l'exposant du résultat en virgule flottante est directement fourni par la position du bit de poids le plus fort de la mantisse.

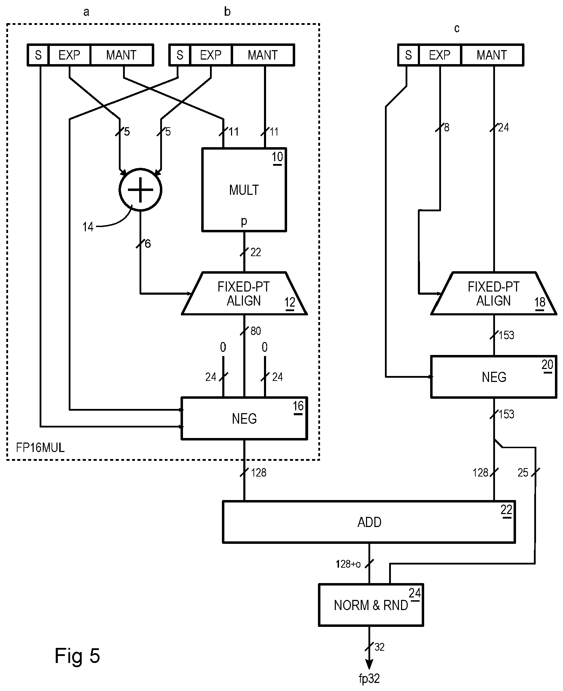

La figure 5 est un schéma bloc d'un opérateur FMA à précision mixte (fp16/fp32) mettant en œuvre la technique des figures 4A et 4B. On notera que les schémas exposés ici sont simplifiés et n'illustrent que les éléments utiles à comprendre l'invention. Certains éléments requis classiquement pour traiter des spécificités des nombres à virgule flottante standardisés, comme les nombres sous-normaux, les nombres non définis (NaN), l'infini, et autres, ne sont pas décrits.

L'opérateur FMA comprend une unité de multiplication de nombres à virgule flottante FP16MUL fournissant un résultat en virgule fixe de 80 bits. L'unité reçoit deux multiplicandes a et b au format fp16 (ou binary16). Chacun des multiplicandes comprend un bit de signe S, un exposant EXP de 5 bits, et une mantisse MANT de 10+1 bits (dont le bit le plus significatif, implicitement à 1, n'est pas stocké). Les deux mantisses sont fournies à un multiplieur 10 qui calcule un produit p sous la forme d'un nombre entier de 22 bits. Le produit p est fourni à un circuit d'alignement 12 qui est commandé par un additionneur 14 produisant la somme des exposants des multiplicandes a et b. Le circuit d'alignement 12 est configuré pour aligner les 22 bits du produit p sur 80 lignes, à la position définie par la somme des exposants, plus 1, selon ce qui a été décrit en relation avec la figure 3. Le circuit 12 opère ainsi une conversion du résultat à virgule flottante de la multiplication vers un nombre à virgule fixe de 80 bits.

Comme on l'a évoqué en relation avec les figures 4A et 4B, les 80 bits de sortie du circuit d'alignement sont complétés à gauche et à droite par 24 bits à 0 pour former un nombre à virgule fixe de 128 bits, qui forme la valeur absolue du produit. Cette valeur absolue de 128 bits est passée par un circuit de négation 16 configuré pour inverser le signe de la valeur absolue lorsque les signes des multiplicandes sont opposés. Dans le cas d'un signe négatif, le circuit de négation rajoute le bit de signe, à 1, à gauche des 80 bits en sortie du registre. Le nombre de 128 bits ainsi produit par le circuit de négation 16 forme la sortie de l'unité de multiplication FP16MUL.

L'opérande d'addition c fourni à l'opérateur FMA, en format fp32 (ou binary32) comprend un bit de signe S, un exposant EXP de 8 bits, et une mantisse MANT de 23+1 bits. La mantisse est fournie à un circuit d'alignement 18 qui est commandé par l'exposant de l'opérande c. Le circuit 18 est configuré pour aligner les 24 bits de la mantisse sur 153 lignes, à une position définie par l'exposant, comme on l'a évoqué en relation avec la figure 4A. Le circuit 18 opère ainsi une conversion de l'opérande à virgule flottante vers un nombre à virgule fixe de 153 bits.

Rappelons que les 153 bits ne suffisent pas à couvrir toute la dynamique de l'exposant d'un nombre fp32, mais seulement les exposants compris entre 56 et -73, la valeur 56 correspondant à la position du bit de poids le plus fort du nombre de 153 bits. Ainsi, le circuit 18 peut être configuré pour saturer l'exposant aux bornes 56 et -73. Il en résulte alors que la mantisse est calée à gauche ou à droite du nombre de 153 bits lorsque l'exposant est hors limites. De toute façon, comme on l'a évoqué en relation avec la figure 4B, les cas hors limites sont traités différemment.

Le nombre fourni par le circuit 18 est passé par un circuit de négation 20 commandé par le bit de signe de l'opérande. Alternativement, il est possible d'omettre le circuit 20 et, au niveau du circuit 16, inverser le signe du produit s'il n'est pas égal à celui de l'opérande c.

Un additionneur de 128 bits 22 reçoit la sortie de l'unité FP16MUL et les 128 bits de poids fort du nombre signé de 153 bits fourni par le circuit de négation 20. Le résultat de l'addition est un nombre à virgule fixe de 128+o bits, où o représente quelques bits pour tenir compte d'éventuelles propagations de retenue. Les 25 bits de poids faible de la sortie du circuit de négation sont utilisés en aval dans le calcul de l'arrondi.

La sortie de l'additionneur 22 est traitée par un circuit de normalisation et arrondi 24 qui a pour fonction de convertir le résultat à virgule fixe de l'addition en un nombre à virgule flottante au format fp32. Pour cela, comme évoqué en relation avec les figures 4A et 4B, la mantisse du nombre fp32 est prise sur les 24 bits les plus significatifs du résultat de l'addition, et l'exposant est déterminé par la position du bit de poids le plus fort de la mantisse dans le résultat de l'addition. L'arrondi est calculé de manière correcte, dans le cas général, sur les bits suivant immédiatement la mantisse dans le résultat de l'addition, suivis à leur tour des 25 bits de poids faible de la sortie du circuit de négation 20.

La figure 5 n'illustre pas d'éventuels éléments de circuit pour traiter les cas hors-limites où l'exposant de l'opérande c est supérieur ou égal à 57, ou inférieur ou égal à -74. Ces éléments sont triviaux compte tenu de la fonctionnalité décrite et plusieurs variantes sont possibles.

Par exemple, lorsque l'exposant est supérieur ou égal à 57, le circuit 24 trouve la mantisse calée à gauche dans le résultat de l'addition, prend directement l'exposant de l'opérande c (au lieu de la position de la mantisse), et calcule l'arrondi en considérant le bit de garde G à 0 et en utilisant les bits situés après la mantisse dans le résultat de l'addition pour déterminer le bit collant S. Le bit d'arrondi R est considéré à 0 si le contenu du registre REG80 est positif, ou à 1 si le contenu du registre REG80 est négatif.

Lorsque l'exposant est inférieur ou égal à -74, le circuit 24 peut opérer comme pour le cas nominal, la mantisse de l'opérande c, calée à droite dans les 25 bits externes à l'additionneur, contribuant à la valeur du bit collant S.

Bien entendu, si le produit est nul, le résultat de l'addition est directement l'opérande c.

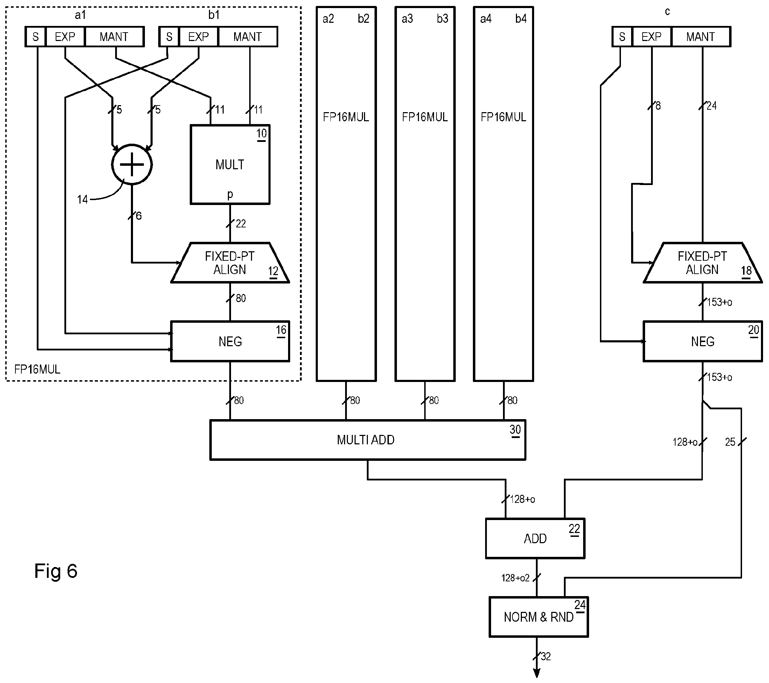

La figure 6 est un schéma de principe d'un mode de réalisation d'opérateur de produit scalaire et accumulation de précision mixte utilisant la technique des figures 4A et 4B pour réaliser un arrondi correct.

Par rapport à l'opérateur FMA de la figure 5, l'opérateur de produit scalaire et accumulation a pour objectif de sommer plusieurs produits partiels, par exemple quatre ici, et un opérande d'addition c. Chaque produit partiel est calculé par une unité FP16MUL respective du type de la figure 5. Les résultats de multiplication sont exprimés en virgule fixe sur 80 bits, qui n'ont pas besoin ici d'être complétés à gauche et à droite par 24 bits fixes. Les quatre résultats de produit partiel à virgule fixe sont fournis à un multi-additionneur de 80 bits 30.

Le multi-additionneur 30 peut avoir une variété de structures classiques. Pour quatre opérandes d'addition, on peut utiliser une structure hiérarchique de trois additionneurs complets, ou une structure à base d'additionneurs à sauvegarde de retenue dits CSA (« Carry-Save Adder »), comme cela est décrit dans la demande de brevet US 2018/0321938, à la différence près que les opérandes d'addition sont ici des nombres de 80 bits en virgule fixe, chacun de taille suffisante pour couvrir toute la dynamique du produit partiel correspondant.

Le résultat du multi-additionneur a la caractéristique d'être exact, quelles que soient les valeurs des produits partiels. Notamment, deux produits partiels grands peuvent s'annuler sans que cela n'affecte l'exactitude du résultat, puisque tous les bits des produits partiels sont conservés à ce stade. Dans les opérateurs classiques, un arrondi est opéré dès cette addition de produits partiels.

En outre, chaque unité de multiplication FP16MUL est indépendante des autres, car il n'est pas nécessaire de comparer les exposants des produits partiels pour opérer un alignement relatif des mantisses des produits partiels. En effet, chaque unité opère une conversion vers le même format à virgule fixe, commun à tous les nombres. Il en résulte qu'il est particulièrement aisé au niveau de la conception de faire varier le nombre d'unités de multiplication selon les besoins, car il n'y a pas d'interdépendances entre les unités de multiplication. L'adaptation de la structure du multi-additionneur en fonction du nombre d'opérandes est aisée également, car elle est faite selon des règles systématiques. La complexité de l'opérateur peut ainsi être maintenue proportionnelle au nombre d'unités de multiplication.

Le résultat de l'addition des produits partiels peut déborder des 80 bits. Ainsi, le résultat est codé sur 80+o bits, où o désigne un petit nombre de bits de poids fort supplémentaires pour accueillir le débordement, égal au logarithme en base 2 du nombre de produits partiels à ajouter, plus le bit de signe. Ainsi, pour quatre produits partiels à additionner, on aura o = 3.

Le nombre à virgule fixe de 80+o bits ainsi fourni par le multi-additionneur est à additionner avec l'opérande d'addition c, converti en virgule fixe sur une dynamique limitée, comme cela a été exposé en relation avec les figures 4A et 4B. La dynamique limitée est basée ici sur une taille de 80+o bits au lieu de 80 bits. Ainsi, comme cela est illustré à droite pour le traitement de l'opérande d'addition c, le circuit d'alignement 18 opère une conversion vers un nombre à virgule fixe de 153+o bits, et le traitement en aval est adapté en conséquence. En particulier on fournit les 128+o bits de poids fort à l'additionneur 22 du côté de l'opérande c. Du côté de la somme de produits partiels, les 80 + o bits fournis par le multi-additionneur 30 sont complétés à gauche et à droite par 24 bits de valeur fixe (0 pour un résultat positif ou 1 pour un résultat négatif).

La sortie de l'additionneur 22 est traitée comme à la figure 5, excepté que le nombre de bits 128+o2 est légèrement plus grand, o2 incluant les o bits et un ou plusieurs bits de plus pour accueillir un débordement de l'additionneur 22.

Ainsi, cette structure d'opérateur ne réalise qu'un seul arrondi, au moment de la conversion du résultat de l'addition finale en nombre à virgule flottante, et ce seul arrondi est calculé de manière correcte en toutes circonstances.

De nombreuses variantes et modifications des modes de réalisation décrits apparaîtront à l'homme du métier. Les opérateurs illustrés aux figures 5 et 6 ont été décrits sous forme de circuits à logique combinatoire. Dans un cœur de processeur cadencé à une fréquence relativement rapide, le temps de réaction de l'opérateur purement en logique combinatoire peut être trop lent. Dans ce cas les opérateurs peuvent avoir une structure en pipeline, en prévoyant, des registres pour stocker des résultats intermédiaires, par exemple, pour stocker les nombres en sortie des circuits d'alignement 12 et 18 (comme cela a d'ailleurs été évoqué en relation avec la figure 3).

Bien que l'on ait décrit des opérateurs de précision mixte exploitant les formats fp16 et fp32, qui ont aujourd'hui un réel intérêt en termes de rapport performance/complexité, les principes sont applicables en théorie à d'autres formats de précision standardisés ou non-standardisés.

## Revendications

1. Opérateur matériel de calcul de produit scalaire, comprenant :
• plusieurs multiplieurs (10) recevant chacun deux multiplicandes (a, b) sous forme de nombres à virgule flottante codés dans un premier format de précision (fp16) ;
• un circuit d'alignement (12) associé à chaque multiplieur, configuré pour, sur la base des exposants des multiplicandes correspondants, convertir le résultat de la multiplication en un nombre à virgule fixe respectif ayant un nombre de bits suffisant (80) pour couvrir toute la dynamique de la multiplication ; et
• un multi-additionneur (30) configuré pour additionner sans perte les nombres à virgule fixe provenant des multiplieurs, fournissant une somme sous forme de nombre à virgule fixe.

2. Opérateur selon la revendication 1, comprenant en outre :
• une entrée pour un opérande d'addition (c) à virgule flottante codé dans un deuxième format de précision (fp32) ayant une précision supérieure au premier format de précision ;
• un circuit d'alignement (18) associé à l'opérande d'addition (c), configuré pour, sur la base de l'exposant de l'opérande d'addition, convertir l'opérande d'addition en un nombre à virgule fixe de dynamique réduite par rapport à la dynamique de l'opérande d'addition, ayant un nombre de bits (153) égal au nombre de bits de la somme à virgule fixe, augmenté de part et d'autre d'au moins la taille (24) de la mantisse de l'opérande d'addition ; et
• un additionneur (22) configuré pour additionner sans perte la somme à virgule fixe et le nombre à virgule fixe de dynamique réduite.

3. Opérateur selon la revendication 2, comprenant un circuit d'arrondi et de normalisation configuré pour convertir le résultat de l'additionneur en un nombre à virgule flottante codé dans le deuxième format de précision, en prenant la mantisse sur les bits les plus significatifs du résultat de l'additionneur, calculant l'arrondi à partir des bits restants du résultat de l'additionneur, et déterminant l'exposant à partir de la position du bit le plus significatif dans le résultat de l'additionneur.

4. Opérateur selon la revendication 3, dans lequel :
• le nombre à virgule fixe de dynamique réduite est étendu à droite par un nombre de bits au moins égal à la taille de la mantisse de l'opérande d'addition ; et
• le circuit d'arrondi utilise les bits de l'extension du nombre à virgule fixe de dynamique réduite pour calculer l'arrondi.

5. Opérateur selon la revendication 3, configuré pour fournir comme résultat l'opérande d'addition lorsque l'exposant de l'opérande d'addition excède la capacité du nombre à virgule fixe de dynamique réduite.

6. Procédé de calcul d'un produit scalaire de nombres binaires, comprenant les étapes suivantes :
• calculer plusieurs multiplications (10) en parallèle, chacune à partir de deux multiplicandes (a, b) sous forme de nombres à virgule flottante codés dans un premier format de précision (fp16) ;
• sur la base des exposants des multiplicandes de chaque multiplication, convertir (12) le résultat de la multiplication correspondante en un nombre à virgule fixe respectif ayant un nombre de bits suffisant (80) pour couvrir toute la dynamique de la multiplication ; et
• additionner (30) sans perte les nombres à virgule fixe résultant des multiplications pour produire une somme sous forme de nombre à virgule fixe.

7. Procédé selon la revendication 6, comprenant en outre les étapes suivantes :
• recevoir un opérande d'addition (c) à virgule flottante codé dans un deuxième format de précision (fp32) ayant une précision supérieure au premier format de précision ;
• sur la base de l'exposant de l'opérande d'addition, convertir l'opérande d'addition en un nombre à virgule fixe de dynamique réduite par rapport à la dynamique de l'opérande d'addition, ayant un nombre de bits (153) égal au nombre de bits de la somme à virgule fixe, augmenté de part et d'autre d'au moins la taille (24) de la mantisse de l'opérande d'addition ; et
• additionner sans perte la somme à virgule fixe et le nombre à virgule fixe de dynamique réduite.

## Patentansprüche

1. Hardware-Operator zur Skalarproduktberechnung, umfassend:
• mehrere Multiplizierer (10), die jeweils zwei Multiplikanden (a, b) in Form von in einem ersten Präzisionsformat (fp16) codierten Gleitkommazahlen empfangen;
• eine Ausrichtungsschaltung (12), die jedem Multiplizierer zugeordnet ist und dazu ausgelegt ist, auf der Basis der Exponenten der entsprechenden Multiplikanden das Ergebnis der Multiplikation in eine jeweilige Festkommazahl umzuwandeln, die eine ausreichende Anzahl von Bits (80) aufweist, um die gesamte Dynamik der Multiplikation abzudecken; und
• einen Multi-Addierer (30), der dazu ausgelegt ist, die von den Multiplizierern stammenden Festkommazahlen verlustfrei zu addieren und eine Summe in Form einer Festkommazahl auszugeben.

2. Operator nach Anspruch 1, umfassend ferner:
• einen Eingang für einen Gleitkomma-Additionsoperanden (c), der in einem zweiten Präzisionsformat (fp32) codiert ist, das eine höhere Präzision als das erste Präzisionsformat aufweist;
• eine Ausrichtungsschaltung (18), die dem Additionsoperanden (c) zugeordnet ist und dazu ausgelegt ist, auf der Basis des Exponenten des Additionsoperanden den Additionsoperanden in eine Festkommazahl mit einer im Vergleich zur Dynamik des Additionsoperanden reduzierten Dynamik umzuwandeln, die eine Anzahl von Bits (153) aufweist, die gleich der Anzahl von Bits der Festkommasumme ist, beidseitig erhöht um mindestens die Größe (24) der Mantisse des Additionsoperanden; und
• einen Addierer (22), der dazu ausgelegt ist, die Festkommasumme und die Festkommazahl mit reduzierter Dynamik verlustfrei zu addieren.

3. Operator nach Anspruch 2, umfassend eine Rundungs- und Normalisierungsschaltung, die dazu ausgelegt ist, das Ergebnis des Addierers in eine in dem zweiten Präzisionsformat codierte Gleitkommazahl umzuwandeln, indem die Mantisse für die höchstwertigen Bits des Ergebnisses des Addierers genommen wird, die Rundung ausgehend von den verbleibenden Bits des Ergebnisses des Addierers berechnet wird und der Exponent ausgehend von der Position des höchstwertigen Bits im Ergebnis des Addierers bestimmt wird.

4. Operator nach Anspruch 3, wobei:
• die Festkommazahl mit reduzierter Dynamik rechts um eine Anzahl von Bits erweitert wird, die mindestens gleich der Größe der Mantisse des Additionsoperanden ist; und
• die Rundungsschaltung die Bits der Erweiterung der Festkommazahl mit reduzierter Dynamik verwendet, um die Rundung zu berechnen.

5. Operator nach Anspruch 3, der dazu ausgelegt ist, als Ergebnis den Additionsoperanden auszugeben, wenn der Exponent des Additionsoperanden die Kapazität der Festkommazahl mit reduzierter Dynamik überschreitet.

6. Verfahren zur Berechnung eines Skalarprodukts von Binärzahlen, umfassend die folgenden Schritte:
• paralleles Berechnen mehrerer Multiplikationen (10), jede ausgehend von zwei Multiplikanden (a, b) in Form von in einem ersten Präzisionsformat (fp16) codierten Gleitkommazahlen;
• auf der Basis der Exponenten der Multiplikanden jeder Multiplikation, Umwandeln (12) des Ergebnisses der entsprechenden Multiplikation in eine jeweilige Festkommazahl, die eine ausreichende Anzahl von Bits (80) aufweist, um die gesamte Dynamik der Multiplikation abzudecken; und
• verlustfreies Addieren (30) der aus den Multiplikationen resultierenden Festkommazahlen, um eine Summe in Form einer Festkommazahl zu erzeugen.

7. Verfahren nach Anspruch 6, umfassend ferner die folgenden Schritte:
• Empfangen eines Gleitkomma-Additionsoperanden (c), der in einem zweiten Präzisionsformat (fp32) codiert ist, das eine höhere Präzision als das erste Präzisionsformat aufweist;
• auf der Basis des Exponenten des Additionsoperanden, Umwandeln des Additionsoperanden in eine Festkommazahl mit einer im Vergleich zur Dynamik des Additionsoperanden reduzierten Dynamik, die eine Anzahl von Bits (153) aufweist, die gleich der Anzahl von Bits der Festkommasumme ist, beidseitig erhöht um mindestens die Größe (24) der Mantisse des Additionsoperanden; und
• verlustfreies Addieren der Festkommasumme und der Festkommazahl mit reduzierter Dynamik.

## Claims

1. A hardware operator for dot-product computation, comprising:
• a plurality of multipliers (10) each receiving two multiplicands (a, b) in the form of floating-point numbers encoded in a first precision format (fp16);
• an alignment circuit (12) associated with each multiplier, configured to, based on the exponents of the corresponding multiplicands, convert the result of the multiplication into a respective fixed-point number having a sufficient number of bits (80) to cover the full dynamic range of the multiplication; and
• a multiadder (30) configured to add without loss the fixed-point numbers provided by the multipliers, providing a sum in the form of a fixed-point number.

2. The operator according to claim 1, further comprising:
• an input for a floating-point addition operand (c) encoded in a second precision format (fp32) having a higher precision than the first precision format;
• an alignment circuit (18) associated with the addition operand (c), configured to, based on the exponent of the addition operand, convert the addition operand into a fixed-point number of reduced dynamic range relative to the dynamic range of the addition operand, having a number of bits (153) equal to the number of bits of the fixed-point sum, extended on either side by at least the size (24) of the mantissa of the addition operand; and
• an adder (22) configured to add without loss the fixed-point sum and the fixed-point number of reduced dynamic range.

3. The operator according to claim 2, comprising a rounding and normalization circuit configured to convert the adder result into a floating-point number encoded in the second precision format, taking the mantissa from the most significant bits of the adder result, calculating the rounding from the remaining bits of the adder result, and determining the exponent from the position of the most significant bit in the adder result.

4. The operator according to claim 3, wherein:
• the fixed-point number of reduced dynamic range is extended to the right by a number of bits at least equal to the size of the mantissa of the addition operand; and
• the rounding circuit uses the bits of the extension of the fixed-point number of reduced dynamic range to calculate the rounding.

5. The operator according to claim 3, configured to provide as a result the addition operand when the exponent of the addition operand exceeds the capacity of the fixed-point number of reduced dynamic range.

6. A method of calculating a dot-product of binary numbers, comprising the steps of:
• calculating a plurality of multiplications (10) in parallel, each from two multiplicands (a, b) that are floating-point numbers encoded in a first precision format (fp16);
• based on the exponents of the multiplicands of each multiplication, converting (12) the result of the corresponding multiplication into a respective fixed-point number having a sufficient number of bits (80) to cover the full dynamic range of the multiplication; and
• adding (30) without loss the fixed-point numbers resulting from the multiplications to produce a sum in the form of a fixed-point number.

7. The method according to claim 6, further comprising the following steps:
• receiving a floating-point addition operand (c) encoded in a second precision format (fp32) having a higher precision than the first precision format;
• on the basis of the exponent of the addition operand, converting the addition operand into a fixed-point number having a reduced dynamic range relative to the dynamic range of the addition operand, having a number of bits (153) equal to the number of bits of the fixed-point sum, extended on both sides by at least the size (24) of the mantissa of the addition operand; and
• adding without loss the fixed-point sum and the fixed-point number of reduced dynamic range.
